# EUROPEAN PATENT SPECIFICATION

(11) **EP 3 140 835 B1**
(45) Date of publication and mention of the grant of the patent: **04.04.2018**
(21) Application number: 15724448.4
(22) Date of filing: 07.05.2015
(51) Int. Cl.: G21K 1/02

(54) **X-RAY ANTI-SCATTER GRID**
STREUSCHUTZGITTER FÜR RÖNTGENSTRAHLEN
GRILLE ANTI-DIFFUSION DE RAYONS X

(30) Priority: 08.05.2014 US 201414273017
(43) Date of publication of application: 15.03.2017
(73) Proprietor: General Electric Company, Schenectady, NY 12345 (US)
(72) Inventor: SCHAEPKENS, Marc, Troy, New York 12180 (US)
(74) Representative: Bedford, Grant Richard
(86) International application number: PCT/US2015/029717
(87) International publication number: WO 2015/171913

(56) References cited:
- WO-A1-2009/128550
- US-A1- 2012 099 705

## Description

### BACKGROUND

The invention generally relates to X-ray radiographic imaging. More specifically, the invention relates to X-ray anti-scatter grids for improving X-ray image quality.

The use of digital radiological imaging continues to be invaluable with respect to a variety of technical applications. Digital radiological imaging is a mainstay in the medical field allowing health care professionals to quickly discern and diagnose internal abnormalities of their patients. Additionally, its use has become increasingly important in industrial fields for visualizing internal contents of parts, baggage, parcels, and other objects, and for visualizing the structural integrity of objects and other purposes. Indeed, the evolution of digital X-ray detectors has enhanced both workflow and image quality in the field of radiological imaging.

Generally, radiological imaging involves the generation of X-rays that are directed toward an object of interest. The X-rays pass through and around the object and then impact an X-ray film, X-ray cassette, or digital X-ray detector. In the context of the digital X-ray detector, these X-ray photons traverse a scintillator that converts the X-ray photons to visible light, or optical photons. The optical photons then collide with the photodetectors of a digital X-ray receptor and are converted to electrical signals which are then processed as digital images that can be readily viewed, stored, and/or transmitted electronically.

To reduce scatter radiation from reaching the detecting medium, X-ray anti-scatter grid have been suggested and used. Anti-scatter grids commonly include a plurality of septa made of highly X-ray absorbing materials, separated by less X-ray absorbent materials. The drawback of this approach to reducing scattered radiation is that not only scatter radiation is absorbed in the anti-scatter grid, but also part of the direct radiation will be absorbed which can have image quality degrading effects, or can lead to having to expose the object (or patient) to higher doses to get the same image quality.

Anti-scatter grids are typically fabricated from thin sheets of X-ray absorbing material arranged in a geometric pattern to absorb scattered radiation, and a less X-ray absorbent material between absorbent sheets that allows most direct radiation to pass through the anti-scatter grid. Focused anti-scatter grids are typically manufactured by aligning the grid components during assembly to obtain the desired focus. One particularly attractive method for producing grids relies on the formation of very fine slits in a graphite material in a focused pattern, such as graphite, and the slits are filled with X-ray absorbing material, such as lead-bismuth alloy, to form a focused grid. See, for example, U.S. Pat. Nos. 5,557,650 and 5,581,592. This manufacturing process, however, is sensitive to pores that invariably exist in most graphite materials. When the very fine slits are machined into the graphite, one can cut through a pore. When filling the slit subsequently with lead-bismuth, the pore also fills up, thus forming a X-ray absorbing location in the grid at locations where high X-ray transparency is desired.

### SUMMARY OF THE INVENTION

In one embodiment, the invention provides an X-ray anti-scatter grid assembly. The X-ray anti-scatter assembly includes a boron-nitride substrate and X-ray absorbing septa coupled to the boron-nitride substrate.

In another embodiment, the invention provides a method of making an X-ray anti-scatter grid. The method includes providing a boron-nitride substrate and coupling X-ray absorbing septa to the boron-nitride substrate.

### BRIEF DESCRIPTION OF THE DRAWINGS

FIG. 1 is a cross-sectional view of an X-ray anti-scatter grid assembly according to one aspect of the invention.
FIG. 2 is a cross-sectional view of a boron nitride substrate.
FIG. 3 is a cross-sectional view of the boron nitride substrate of FIG. 2 after machining a plurality channels.
FIG. 4 is a cross-sectional view of the boron nitride substrate of FIG. 3, after filling the channels with an X-ray absorbing material.

### DETAILED DESRIPTION

In the following detailed description, reference is made to the accompanying drawings that form a part hereof, and in which is shown by way of illustration specific embodiments, which may be practiced. These embodiments are described in sufficient detail to enable those skilled in the art to practice the embodiments, and it is to be understood that other embodiments may be utilized and that logical, mechanical, electrical and other changes may be made without departing from the scope of the embodiments. The following detailed description is, therefore, not to be taken in a limiting sense.

The present invention is a X-ray anti-scatter grid article that comprises a highly X-ray transparent, substantially pore free, boron nitride substrate material with very fine slits machined in a focused pattern, the slits subsequently filled with lead-bismuth alloy so the filled grids form into X-ray absorbing septa of a focused grid. In another embodiment the substantially pore free, boron nitride substrate material is at least partly removed between the X-ray absorbing septa. Another aspect of this invention is the method of making said anti-scatter grid articles.

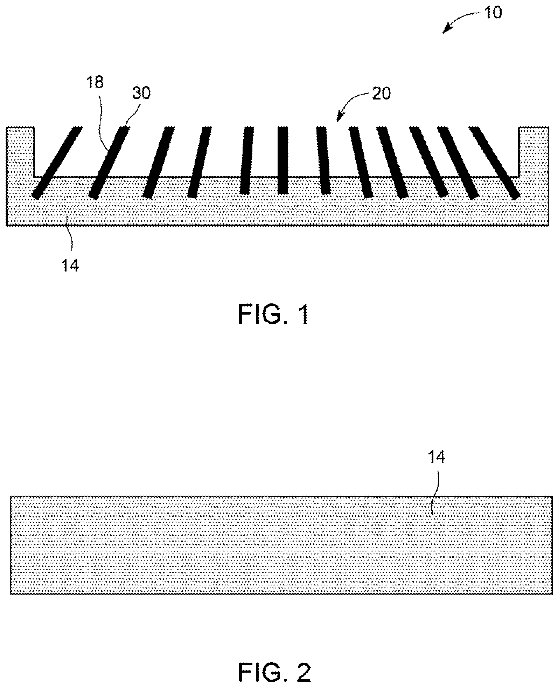

Referring to FIG. 1, an anti-scatter grid 10 according to the present invention includes a boron-nitride substrate 14 and a plurality of septa 18 arranged to form a septa grid 20.

Referring to FIG. 2, the boron-nitride substrate 14 may be provided in the form of a hot pressed boron nitride ceramic sheet that is compacted at temperatures up to 2000 degrees C and pressures up to 2000 psi to form a dense, strong engineering material that is easily machined. In another embodiment the boron nitride substrate 14 can be a pyrolitic boron nitride (PBN) material that is chemically vapor deposited (CVD) at temperatures between 1400 degrees C and over 2000 degrees C.

Due to the nature of manufacturing (crystallization or atom by atom deposition), these boron nitride materials are intrinsically unlikely to contain pores that would be of the size that would be problematic in the anti-scatter grid manufacturing process. Commonly used graphite materials (see Background), on the other hand, are very prone to exhibit pores of sizes that are relevant.

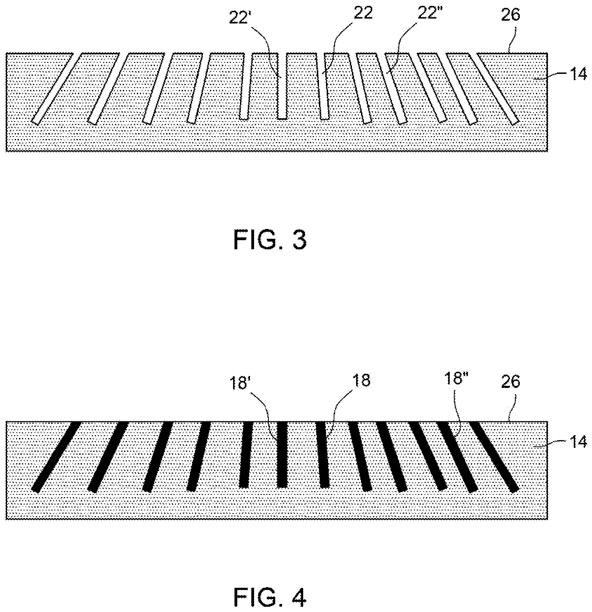

Referring to FIG. 3, a plurality of narrow (i.e., fine) channels 22 are formed into the boron nitride substrate 14 by a material removal process, such as machining. The channels 22 may be cut using either a plurality of blades arranged side by side to cut the channels simultaneously or a single blade can cut each of the channels sequentially. If the blade is not of sufficient depth, then one fabrication technique is to turn the substrate over and cut on the opposite surface of the substrate to form a channel having two portions. Preferably, for ease of later fabrication, the channels 22 do not extend completely through the substrate 14.

The channel configuration may be one of several types. In the illustrated embodiment, at least one channel 22 (e.g., channel 22') is oriented substantially perpendicular to a surface 26 of the substrate 14. In some embodiments, all of the channels are each perpendicular to the surface of the substrate. In the illustrated embodiment, some of the channels 22 (e.g., channel 22") are oriented at a non-perpendicular angle to the surface 26 to form a focused grid. Commercially available cutting saws typically cut perpendicular to flat substrates. If a non-perpendicular angle is desired, the angle can be obtained, for example, using a substrate support surface which is rotatable for providing the desired angle of substrate channel. Even if angled channels are not desired, a movable support table for use under the substrate such as available from Anorad Corporation of Hauppaugue, N.Y., is useful because blades for machining are not always large enough (or do not always have enough range of motion) to create the desired length of channels.

The channels 22 are not limited to the rectangular shapes obtainable with the above described cutting saw. The channels 22 can alternatively be round or comprise other types of cavities and can be formed by any of a number of methods such as etching, molding, heat deforming and/or reforming, milling, drilling, or any combination thereof.

Another benefit of using boron nitride over graphite as a substrate material is that it is substantially easier to machine than most graphite compositions. It is not uncommon that cutting blades need to be replaced during the machining of a single focused grid in current manufacturing. Easy to machine boron nitride materials will substantially lengthen the life of cutting blades.

Referring to FIG. 4, the septa 18 may be formed by first filling the channels 22 (FIG. 3) with an absorber material. As a result of the orientation of the channels 22, the septa 18 may be oriented perpendicular to the surface 26 (e.g., septa 18'), or non-perpendicular to the surface (e.g., septa 18"). In one embodiment of the present invention, the channels 22 are filled under vacuum conditions with an absorbing material that can be readily melt-flowed into the channels. In a preferred embodiment the absorbing material comprises a lead-bismuth alloy. An alloy commercially available from Belmont Metals of Brooklyn, N.Y., has a eutectic at 44% lead-56% bismuth with a melting point of 125 degrees Celsius. 50% lead-50% bismuth would also be advantageously close to the eutectic. This is the preferred filling material since it forms a low melting point eutectic and it has a mass absorption coefficient of 3.23 at 125 KeV, which is superior to that of pure lead (3.15 at 125 KeV). Other substantially absorbent materials can include metals such as lead, bismuth, gold, barium, tungsten, platinum, mercury, thallium, indium, palladium, silicon, antimony, tin, zinc, and alloys thereof.

Referring to FIG. 1, the boron nitride substrate 14 is removed around distal portions 30 of the septa 18. The boron nitride substrate 14 can be readily removed with various methods, including fluorinated plasma etching. When one exposes the boron nitride substrate 14 and septa grid 20 to fluorinated plasma, the plasma will remove the boron nitride material, while leaving typical highly X-ray absorbing materials like lead-bismuth alloys in place (see Figure 1d). It is thus possible to further increase the X-ray transmission of the anti-scatter grid 10, which will result in even higher X-ray image quality or can be used to reduce the total dose used for X-ray imaging.

It was also unexpectedly found that boron nitride can also be more X-ray transparent than graphite. X-ray transmission measurements taken on pyrolitic boron nitride (PBN) material by using the image chain substantially similar to a GE Senograph Essential system showed that the boron nitride material had a higher X-ray transparency in clinically relevant X-ray energy ranges than graphite materials (e.g. when compared to pyrolitic graphite as reference material). More specifically, when placing a 1.18 mm thick PBN plate on top of a GE Senograph Essential large-Field of View (LFOV) mammography detector and irradiating the PBN plate with a typical mammography spectrum, it was found that roughly 90.2% to 91.7% of the X-ray flux was transmitted through the PBN plate. Extrapolating to a 1.4mm thick plate, which is similar to what is commonly used as thickness of anti-scatter grids for mammography, one would expect 88.3% to 90.2% transmission.

Comparing these results to similar measurements taken on a 0.4 mm thick plate of thermally annealed pyrolitic graphite (TPG), it was measured that roughly 95.5% to 96.4% transmission occurred which when extrapolated to a 1.4 mm thick plate would result in 85%-88% transmission. These measurements thus indicate that PBN is more transparent than TPG in X-ray energy regions clinically relevant to, for example, mammography (i.e. around 30 keV). Based on published X-ray attenuation curves as function of energy, it can be concluded that this conclusion holds true across the entire energy range relevant to medical X-ray imaging.

Finally, boron nitride can be readily removed with various methods, including fluorinated plasma etching. When one exposes a grid of the invention above to fluorinated plasma, the plasma will remove the boron nitride material while leaving typical highly X-ray absorbing materials like lead-bismuth alloys in place (see Figure 1d). It is thus possible to further increase the X-ray transmission of the anti-scatter grid, which will result in even higher X-ray image quality or can be used to reduce the total dose used for X-ray imaging.

Thus the invention provides an X-ray anti-scatter grid and a method of manufacturing an X-ray anti-scatter grid. Various features of the invention are set forth in the following claims.

## Claims

1. An X-ray anti-scatter assembly (10), comprising:
a boron-nitride substrate (14); and
X-ray absorbing septa (18) coupled to the boron-nitride substrate (14).

2. The X-ray anti-scatter assembly (10) of claim 1, wherein the X-ray absorbing septa (18) comprise a lead or a lead-bismuth alloy.

3. The X-ray anti-scatter assembly (10) of claim 1, wherein the X-ray absorbing septa (18) comprise at least one of bismuth, gold, barium, tungsten, platinum, mercury, thallium, indium, palladium, silicon, antimony, tin, and zinc.

4. The X-ray anti-scatter assembly (10) of claim 1, wherein the septa (18) extend in cantilever fashion from the substrate (14).

5. The X-ray anti-scatter assembly (10) of claim 1, wherein at least some of the septa (18) are disposed at an angle perpendicular to a surface of the substrate (14).

6. The X-ray anti-scatter assembly (10) of claim 1, wherein at least some of the septa (18) are disposed at a substantially non-perpendicular angle with respect to a surface of the substrate (14).

7. The X-ray anti-scatter assembly (10) of claim 1, wherein the boron nitride substrate (14) comprises a hot pressed boron nitride ceramic.

8. The X-ray anti-scatter assembly (10) of claim 1, wherein the boron-nitride substrate (14) comprises a chemically vapor deposited (CVD) pyrolitic boron nitride (PBN) material.

9. A method of manufacturing an X-ray detector, comprising:
providing a boron-nitride substrate (14); and
coupling X-ray absorbing septa (18) to the boron-nitride substrate (14).

10. The method of claim 9, further comprising:
defining channels in the boron-nitride substrate (14).

11. The method of claim 9, further comprising removing a portion of the boron-nitride substrate (14) around the septa (18).

12. The method of claim 9, wherein coupling the septa (18) includes coupling at least one septa at an angle perpendicular to a surface of the substrate (14).

13. The method of claim 9, wherein coupling the septa (18) includes coupling at least one septa at a substantially non-perpendicular angle to a surface of the substrate (14).

14. The method of claim 9, further comprising:
forming the boron-nitride substrate (14) by a chemically vapor depositing a pyrolitic boron nitride (PBN) material.

15. The method of claim 9, further comprising:
forming the boron-nitride substrate (14) of a hot pressed boron nitride ceramic.

## Patentansprüche

1. Röntgenstrahlenstreuschutzbaugruppe (10), umfassend:
ein Bor-Nitrid-Substrat (14); und
Röntgenstrahlen absorbierende Septa (18), die an das Bor-Nitrid-Substrat (14) gekoppelt sind.

2. Röntgenstrahlenstreuschutzbaugruppe (10) nach Anspruch 1, wobei die Röntgenstrahlen absorbierenden Septa (18) eine Blei- oder Blei-Bismut-Legierung umfassen.

3. Röntgenstrahlenstreuschutzbaugruppe (10) nach Anspruch 1, wobei die Röntgenstrahlen absorbierenden Septa (18) zumindest eines von Bismut, Gold, Barium, Wolfram, Platin, Quecksilber, Thallium, Indium, Palladium, Silicium, Antimon, Zinn und Zink umfassen.

4. Röntgenstrahlenstreuschutzbaugruppe (10) nach Anspruch 1, wobei die Septa (18) freitragend vom Substrat (14) verlaufen.

5. Röntgenstrahlenstreuschutzbaugruppe (10) nach Anspruch 1, wobei zumindest einige der Septa (18) in einem lotrechten Winkel zu einer Oberfläche des Substrats (14) angeordnet sind.

6. Röntgenstrahlenstreuschutzbaugruppe (10) nach Anspruch 1, wobei zumindest einige der Septa (18) in einem im Wesentlichen nicht-lotrechten Winkel bezüglich einer Oberfläche des Substrats (14) angeordnet sind.

7. Röntgenstrahlenstreuschutzbaugruppe (10) nach Anspruch 1, wobei das Bor-Nitrid-Substrat (14) eine heißgepresste Bor-Nitrid-Keramik umfasst.

8. Röntgenstrahlenstreuschutzbaugruppe (10) nach Anspruch 1, wobei das Bor-Nitrid-Substrat (14) ein über chemische Gasphasenabscheidung (CVD) abgeschiedenes, pyrolitisches Bor-Nitrid-Material (PBN) umfasst.

9. Verfahren zum Herstellen eines Röntgenstrahlendetektors, umfassend:
Vorsehen eines Bor-Nitrid-Substrats (14); und
Koppeln von Röntgenstrahlen absorbierenden Septa (18) an das Bor-Nitrid-Substrat (14).

10. Verfahren nach Anspruch 9, weiter umfassend:
Definieren von Kanälen im Bor-Nitrid-Substrat (14).

11. Verfahren nach Anspruch 9, weiter umfassend das Entfernen eines Abschnitts des Bor-Nitrid-Substrats (14) um die Septa (18).

12. Verfahren nach Anspruch 9, wobei das Koppeln der Septa (18) das Koppeln von zumindest einem Septum in einem lotrechten Winkel zu einer Oberfläche des Substrats (14) beinhaltet.

13. Verfahren nach Anspruch 9, wobei das Koppeln der Septa (18) das Koppeln von zumindest einem Septum in einem im Wesentlichen nicht-lotrechten Winkel zu einer Oberfläche des Substrats (14) beinhaltet.

14. Verfahren nach Anspruch 9, weiter umfassend:
Ausbilden des Bor-Nitrid-Substrats (14) durch Abscheiden eines pyrolitischen Bor-Nitrid-Materials (PBN) über chemische Gasphasenabscheidung.

15. Verfahren nach Anspruch 9, weiter umfassend:
Ausbilden des Bor-Nitrid-Substrats (14) aus einer heißgepressten Bor-Nitrid-Keramik.

## Revendications

1. Ensemble anti-diffusion de rayons X (10) comprenant :
un substrat de nitrure de bore (14) ; et
des septa (18) absorbant les rayons X couplés au substrat de nitrure de bore (14).

2. Ensemble anti-diffusion de rayons X (10) selon la revendication 1, dans lequel les septa (18) absorbant les rayons X comprennent du plomb ou un alliage de plomb et de bismuth.

3. Ensemble anti-diffusion de rayons X (10) selon la revendication 1, dans lequel les septa (18) absorbant les rayons X comprennent au moins l'un constitué de bismuth, d'or, de baryum, de tungstène, de platine, de mercure, de thallium, d'indium, de palladium, de silicium, d'antimoine, d'étain et de zinc.

4. Ensemble anti-diffusion de rayons X (10) selon la revendication 1, dans lequel les septa (18) s'étendent en porte-à-faux depuis le substrat (14).

5. Ensemble anti-diffusion de rayons X (10) selon la revendication 1, dans lequel au moins certains des septa (18) sont disposés sous un angle perpendiculaire à une surface du substrat (14).

6. Ensemble anti-diffusion de rayons X (10) selon la revendication 1, dans lequel au moins certains des septa (18) sont disposés sous un angle sensiblement non perpendiculaire par rapport à une surface du substrat (14).

7. Ensemble anti-diffusion de rayons X (10) selon la revendication 1, dans lequel le substrat de nitrure de bore (14) comprend une céramique de nitrure de bore comprimée à chaud.

8. Ensemble anti-diffusion de rayons X (10) selon la revendication 1, dans lequel le substrat de nitrure de bore (14) comprend un matériau de nitrure de bore pyrolytique (PBN) déposé en vapeur chimique (CVD).

9. Procédé de fabrication d'un détecteur de rayons X comprenant :
la fourniture d'un substrat de nitrure de bore (14) ; et
le couplage de septa (18) absorbant les rayons X au substrat de nitrure de bore (14).

10. Procédé selon la revendication 9, comprenant en outre :
la définition de canaux dans le substrat de nitrure de bore (14).

11. Procédé selon la revendication 9, comprenant en outre l'élimination d'une partie du substrat de nitrure de bore (14) autour des septa (18).

12. Procédé selon la revendication 9, dans lequel le couplage des septa (18) comprend le couplage d'au moins un septum sous un angle perpendiculaire à une surface du substrat (14).

13. Procédé selon la revendication 9, dans lequel le couplage des septa (18) comprend le couplage d'au moins un septum sous un angle sensiblement non perpendiculaire à une surface du substrat (14).

14. Procédé selon la revendication 9, comprenant en outre :
la formation du substrat de nitrure de bore (14) par une vapeur chimique déposant un matériau de nitrure de bore pyrolytique (PBN).

15. Procédé selon la revendication 9, comprenant en outre :
la formation du substrat de nitrure de bore (14) d'une céramique de nitrure de bore comprimée à chaud.
